# FASCICULE DE BREVET EUROPEEN

(11) **EP 3 080 217 B1**
(45) Date de publication et mention de la délivrance du brevet: **06.02.2019**
(21) Numéro de dépôt: 14827497.0
(22) Date de dépôt: 11.12.2014
(51) Int. Cl.: C09D 153/00, B82Y 40/00, B81C 1/00, G03F 7/00, H01L 21/027

(54) **PROCÉDÉ PERMETTANT LA CRÉATION DE STRUCTURES NANOMÉTRIQUES PAR L'AUTO-ASSEMBLAGE DE COPOLYMÈRES A BLOCS**
VERFAHREN ZUR ERZEUGUNG VON NANOMETRISCHEN STRUKTUREN DURCH SELBSTANORDNUNG VON BLOCKCOPOLYMEREN
METHOD ALLOWING THE CREATION OF NANOMETRIC STRUCTURES BY SELF-ASSEMBLY OF BLOCK COPOLYMERS

(30) Priorité: 13.12.2013 FR 1362594
(43) Date de publication de la demande: 19.10.2016
(73) Titulaire: Arkema France, 92700 Colombes (FR); Centre National de la Recherche Scientifique, 75794 Paris Cedex 16 (FR); Institut Polytechnique de Bordeaux 1, 33402 Talence Cedex (FR); Université de Bordeaux, 33000 Bordeaux (FR)
(72) Inventeur: MUMTAZ, Muhammad, F-33300 Bordeaux (FR); AISSOU, Karim, 33130 Begles (FR); BROCHON, Cyril, F-33700 Merignac (FR); CLOUTET, Eric, 33130 Begles (FR); FLEURY, Guillaume, F-33000 Bordeaux (FR); HADZIIOANNOU, Georges, F-33850 Leognan (FR); NAVARRO, Christophe, F-64100 Bayonne (FR); NICOLET, Celia, 64230 Sauvagnon (FR); CHEVALIER, Xavier, F-38100 Grenoble (FR)
(74) Mandataire: Bonnel, Claudine
(86) Numéro de dépôt international: PCT/FR2014/053277
(87) Numéro de publication internationale: WO 2015/087003

(56) Documents cités:
- QUOC DAT NGHIEM ET AL: "Direct Preparation of High Surface Area Mesoporous SiC-Based Ceramic by Pyrolysis of a Self-Assembled Polycarbosilane- block -Polystyrene Diblock Copolymer", CHEMISTRY OF MATERIALS, vol. 20, no. 11, 1 juin 2008 (2008-06-01), pages 3735-3739, XP055138637, ISSN: 0897-4756, DOI: 10.1021/cm702688j

## Description

L'invention concerne un procédé permettant la création de structures nanométriques par l'auto-assemblage de copolymères à blocs dont au moins un des blocs est constitué de 1,1-diméthyl-silacyclobutane.

L'invention concerne aussi l'utilisation de ces matériaux dans les domaines de la lithographie (masques de lithographie), le stockage de l'information mais également la confection de membranes poreuses ou comme support de catalyseur. L'invention concerne aussi les masques de copolymères à blocs obtenus selon le procédé de l'invention.

Le développement des nanotechnologies a permis de miniaturiser constamment les produits du domaine de la microélectronique et les systèmes micro-électro mécaniques (MEMS) notamment. Aujourd'hui, les techniques de lithographie classiques ne permettent plus de répondre à ces besoins constants de miniaturisation, car elles ne permettent pas de réaliser des structures avec des dimensions inférieures à 60nm.
Il a donc fallu adapter les techniques de lithographie et créer des masques de gravure qui permettent de créer des motifs de plus en plus petits avec une grande résolution. Avec les copolymères à blocs il est possible de structurer l'arrangement des blocs constitutifs des copolymères, par ségrégation de phase entre les blocs formant ainsi des nano-domaines, à des échelles inférieures à 50nm. Du fait de cette capacité à se nano-structurer, l'utilisation des copolymères à blocs dans les domaines de l'électronique ou de l'optoélectronique est maintenant bien connue.
Parmi les masques étudiés pour réaliser de la nano-lithographie, les films de copolymères à blocs, notamment à base de Polystyrène-Poly (méthacrylate de méthyle), noté ci-après PS-b-PMMA, apparaissent comme des solutions très prometteuses car ils permettent de créer des motifs avec une forte résolution. Pour pouvoir utiliser un tel film de copolymère à blocs comme masque de gravure, un bloc du copolymère doit être sélectivement retiré pour créer un film poreux du bloc résiduel, dont les motifs peuvent être ultérieurement transférés par gravure à une couche sous-jacente. Concernant le film de PS-b-PMMA, le bloc minoritaire, c'est-à-dire le PMMA (Poly (méthacrylate de méthyle)), est retiré de manière sélective pour créer un masque de PS (Polystyrène) résiduel.
Pour créer de tels masques, les nano-domaines doivent être orientés perpendiculairement à la surface de la couche sous-jacente. Une telle structuration des domaines nécessite des conditions particulières telles que la préparation de la surface de la couche sous-jacente, mais aussi la composition du copolymère à blocs.
Les ratios entre les blocs permettent de contrôler la forme des nano-domaines et la masse moléculaire de chaque bloc permet de contrôler la dimension des blocs. Un autre facteur très important est le facteur de ségrégation de phase, encore dénommé paramètre d'interaction de Flory-Huggins et noté « χ ». Ce paramètre permet en effet de contrôler la taille des nano-domaines. Plus particulièrement, il définit la tendance des blocs du copolymère à blocs à se séparer en nano-domaines. Ainsi, le produit χN du degré de polymérisation, N, et du paramètre de Flory-Huggins χ, donne une indication sur la compatibilité de deux blocs et s'ils peuvent se séparer. Par exemple, un copolymère di-bloc de composition symétrique se sépare en micro-domaines si le produit χN est supérieur à 10. Si ce produit χN est inférieur à 10, les blocs se mélangent et la séparation de phase n'est pas observée.
Du fait des besoins constants de miniaturisation, on cherche à accroitre ce degré de séparation de phase, afin de réaliser des masques de nano-lithographie permettant d'obtenir de très grandes résolutions, typiquement inférieures à 20nm, et de préférence inférieures à 10nm. Dans Macromolecules, 2008, 41, 9948, Y. Zhao et al ont estimé le paramètre de Flory-Huggins pour un copolymère à blocs de PS-b-PMMA. Le paramètre de Flory-Huggins χ obéit à la relation suivante : χ = a+b/T, où les valeurs a et b sont des valeurs spécifiques constantes dépendantes de la nature des blocs du copolymère et T est la température du traitement thermique appliqué au copolymère à blocs pour lui permettre de s'organiser, c'est-à-dire pour obtenir une séparation de phase des domaines, une orientation des domaines et une réduction du nombre de défauts. Plus particulièrement, les valeurs a et b représentent respectivement les contributions entropique et enthalpique. Ainsi, pour un copolymère à blocs de PS-b-PMMA, le facteur de ségrégation de phase obéit à la relation suivante : χ = 0,0282 + 4,46/T. Par conséquent, même si ce copolymère à blocs permet de générer des tailles de domaines légèrement inférieures à 20 nm, il ne permet pas de descendre beaucoup plus bas en termes de taille de domaines, du fait de la faible valeur de son paramètre d'interaction de Flory-Huggins χ.
Cette faible valeur du paramètre d'interaction de Flory-Huggins limite donc l'intérêt des copolymères à blocs à base de PS et PMMA, pour la réalisation de structures à très grandes résolutions.
Pour contourner ce problème, M.D. Rodwogin et al, ACS Nano, 2010, 4, 725, ont démontré que l'on peut changer la nature chimique des deux blocs du copolymère à blocs afin d'accroitre très fortement le paramètre de Flory-Huggins χ et d'obtenir une morphologie souhaitée avec une très haute résolution, c'est-à-dire dont la taille des nano-domaines est inférieure à 20nm. Ces résultats ont notamment été démontré pour un copolymère triblocs de PLA-b-PDMS-b-PLA (acide polylactique - polydiméthylsiloxane- acide polylactique).
H. Takahashi et al, Macromolecules, 2012, 45, 6253, ont étudié l'influence du paramètre d'interaction de Flory-Huggins χ sur les cinétiques d'assemblage du copolymère et de diminution des défauts dans le copolymère. Ils ont notamment démontré que lorsque ce paramètre χ devient trop important, on assiste généralement à un ralentissement important de la cinétique d'assemblage, de la cinétique de ségrégation de phase entrainant également un ralentissement de la cinétique de diminution des défauts au moment de l'organisation des domaines.
Un autre problème, rapporté par S. Ji &al., ACS Nano, 2012, 6, 5440, se pose également lorsque l'on considère les cinétiques d'organisation des copolymères à blocs contenant une pluralité de blocs tous chimiquement différents les uns des autres. En effet, les cinétiques de diffusion des chaines de polymère, et par là également, les cinétiques d'organisation et de diminution des défauts au sein de la structure auto-assemblée, dépendent des paramètres de ségrégation χ entre chacun des différents blocs. En outre, ces cinétiques sont également ralenties à cause de la nature multi-bloc du copolymère, car les chaines de polymère présentent alors des degrés de liberté moindres pour s'organiser par rapport à un copolymère à blocs comportant moins de blocs.
Les brevets US 8304493 et US 8450418 décrivent un procédé pour modifier des copolymères à blocs, ainsi que des copolymères à blocs modifiés. Ces copolymères à blocs modifiés présentent une valeur du paramètre d'interaction de Flory-Huggins χ modifiée, de manière telle que le copolymère à blocs présente des nano-domaines de petites tailles.
Du fait que les copolymères à blocs PS-b-PMMA permettent déjà d'atteindre des dimensions de l'ordre de 20nm, la demanderesse a cherché une solution pour modifier ce type de copolymère à blocs afin d'obtenir un bon compromis sur le paramètre d'interaction de Flory-Huggins χ, la vitesse et la température d'auto-assemblage.
De manière surprenante, il a été découvert qu'un copolymère à blocs, dont au moins un des blocs comprend le 1,1-diméthyl-silacyclobutane, présente les avantages suivants lorsqu'il est déposé sur une surface :
- Une cinétique d'auto-assemblage rapide (comprise entre 1 et 20 minutes) pour de faibles masses moléculaires conduisant à des tailles de domaines bien inférieurs à 10 nm, et ce à de basses températures (entre 333K et 603 K, et de préférence entre 373 et 603 K).
- La présence d'entités 1,1-diméthyl-silacyclobutane précurseurs de carbures de silicium après traitement plasma ou par pyrolyse qui permettent d'obtenir des masques durs lors de l'étape de gravure du masque.
- l'orientation des domaines lors de l'auto-assemblage de tels copolymères à bloc ne nécessite pas de préparation du support (pas de couche de neutralisation), l'orientation des domaines étant gouvernée par l'épaisseur du film de copolymère à blocs déposé.

Ainsi ces matériaux montrent un très grand intérêt pour les applications en nano-lithographie pour la réalisation de masques de gravure de très faible dimensions et présentant un bon contraste à la gravure ainsi que la réalisation de membranes poreuse ou encore comme support de catalyseur.

### Résumé de l'invention :

L'invention concerne un procédé d'assemblage nano-structuré utilisant une composition comprenant un copolymère à blocs dont au moins un des blocs est constitué de 1,1-diméthyl-silacyclobutane et comprenant les étapes suivantes :
- Mise en solution du copolymère à blocs dans un solvant.
- Dépôt de cette solution sur une surface, la dite surface étant choisie parmi le silicium, le silicium présentant une couche d'oxyde natif ou thermique, le silicium hydrogéné ou halogéné, le germanium, le germanium hydrogéné ou halogéné, le platine et oxyde de platine, le tungstène et oxydes, l'or, les nitrures de titane, les graphènes.
- Recuit.

### Description détaillée :

Par surface on entend une surface qui peut être plane ou non plane.

Par recuit, on entend une étape de chauffage à une certaine température permettant l'évaporation du solvant quand il est présent, et autorisant l'établissement de la nano-structuration recherchée en un temps donné (auto-assemblage).
Par recuit, on entend également l'établissement de la nano-structuration du film de copolymère à bloc lorsque ledit film est soumis à une atmosphère contrôlée de vapeurs de solvant(s), ces vapeurs donnant aux chaines de polymère suffisamment de mobilité pour s'organiser par elles-mêmes sur la surface. Par recuit, on entend également une quelconque combinaison des deux méthodes pré-citées.

Tout copolymère à blocs, quelle que soit sa morphologie associée, pourra être utilisé dans le cadre de l'invention, qu'il s'agisse de copolymère di-blocs, tri-blocs linéaire ou en étoile, multi-blocs linéaires, en peigne ou en étoile, à condition qu'au moins un des monomères constitutifs d'au moins un des blocs du copolymère à blocs présente la structure du 1,1-diméthyl-silacyclobutane . De préférence, il s'agit de copolymères di-blocs ou tri-blocs, et de façon encore préférée de copolymères di-blocs.

Les entités monomériques utilisées dans les copolymères à blocs de l'invention sont le 1,1-diméthyl-silacyclobutane.

Les blocs ne comprenant pas de 1,1-diméthyl-silacyclobutane sont constitués des monomères suivants : au moins un monomère vinylique, vinylidénique, diénique, oléfinique, allylique ou (méth)acrylique ou cyclique. Ces monomères sont choisis plus particulièrement parmi les monomères vinylaromatiques tels que le styrène ou les styrènes substitués notamment l'alpha-méthylstyrène, les monomères acryliques tels les acrylates d'alkyle, de cycloalkyle ou d'aryle tels que l'acrylate de méthyle, d'éthyle, de butyle, d'éthylhexyle ou de phényle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxy-polyéthylèneglycol-polypropylèneglycol ou leurs mélanges, les acrylates d'aminoalkyle tels que l'acrylate de 2-(diméthylamino)éthyle (ADAME), les acrylates fluorés, les acrylates phosphorés tels que les acrylates de phosphate d'alkylèneglycol, les acrylates de glycidyle, de dicyclopentenyloxyethyle, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'étheralkyle tels que le méthacrylate de 2-éthoxyéthyle, les méthacrylates d'alcoxy- ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxy-polyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxy-éthylimidazolidone, le méthacrylate d'hydroxy-éthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, l'hexène et le 1-octène, les monomères dièniques dont le butadiène, l'isoprène ainsi que les monomères oléfiniques fluorés, les monomères vinylidénique, parmi lesquels on peut citer le fluorure de vinylidène, les monomères cycliques parmi lesquels on peut citer les lactones telle l'e-caprolactone, les lactides , glycolides, les carbonates cycliques tel le triméthylènecarbonate, les siloxanes tel l'octaméthylcyclotetrasiloxane, les éthers cycliques tel le trioxane, les amides cyliques telle l'e-caprolactame, les acétals cycliques tel le 1,3-dioxolane, les phosphazènes tel l'hexachlorocyclotriphosphazène, les N-carboxyanhydrides, les esters cycliques phosphorés tels les cyclophosphorinanes, les cyclophospholanes, les oxazolines, le cas échéants protégés pour être compatible avec les procédés de polymérisation anionique, seuls ou en mélange d'au moins deux monomères précités.

De préférence les blocs ne comprenant pas de 1,1-diméthyl-silacyclobutane comprennent du méthacrylate de méthyle dans des proportions massiques supérieures à 50% et de façon préférée supérieures à 80 % et de façon encore préférée supérieures à 95 %.
Les copolymères à blocs utilisés dans l'invention sont préparés par polymérisation anionique séquentielle. Une telle synthèse est bien connue de l'homme du métier. Un premier bloc est préparé selon un protocole décrit par Yamaoka et coll., Macromolecules, 1995, 28, 7029-7031.
Les blocs suivants sont construits de la même manière en additionnant séquentiellement les monomères concernés, le cas échéant précédé d'une étape d'addition de 1,1-diphényle éthylène ou de tout autre molécule connue de l'homme du métier pour permettre le contrôle de la réactivité du centre actif.
Une fois le copolymère à bloc synthétisé, il est dissout dans un solvant adéquat puis déposé sur une surface selon des techniques connues de l'homme de métier comme par exemple la technique dite « spin coating », « docteur Blade » « knife system », « slot die system » mais tout autre technique peut être utilisée telle qu'un dépôt à sec, c'est-à-dire sans passer par une dissolution préalable.Les films ainsi obtenus ont une épaisseur inférieure à 100 nm.

La surface est choisie parmi le silicium, le silicium présentant une couche d'oxyde natif ou thermique, le silicium hydrogéné ou halogéné, le germanium, le germanium hydrogéné ou halogéné, le platine et oxyde de platine, le tungstène et oxydes, l'or, les nitrures de titane, les graphènes. De préférence la surface est minérale et plus préférentiellement du silicium. De manière encore plus préférentielle, la surface est du silicium présentant une couche d'oxyde natif ou thermique.

On notera que dans le cadre de la présente invention, même si on ne l'exclue pas, il n'est pas nécessaire d'effectuer une étape de neutralisation (comme c'est le cas généralement dans l'art antérieur) par l'utilisation de copolymère statistique convenablement choisi. Cela présente un avantage considérable car cette étape de neutralisation est pénalisante (synthèse du copolymère statistique de composition particulière, dépôt sur la surface). L'orientation du copolymère à bloc est définie par l'épaisseur du film de copolymère à blocs déposé. Elle est obtenue dans des temps relativement cours, compris entre 1 et 20 minutes bornes comprises et de préférence compris entre 1 et 5 minutes et à des températures comprises entre 333 et 603 K et de préférence entre 373K et 603 K et de façon encore préférentielle entre 373 et 403 K.

Le procédé de l'invention s'applique avantageusement au domaine de la nano-lithographie utilisant des masques de copolymères à blocs ou plus généralement dans le domaine de la nano-structuration de surfaces pour l'électronique.

Le procédé de l'invention permet également la fabrication de membranes poreuses ou de supports de catalyseurs pour lesquels un des domaines du copolymère à blocs est dégradé afin d'obtenir une structure poreuse.

### Exemple 1 :

### Synthèse de Poly (1,1-diméthyl-silacyclobutane)-bloc-PMMA (PDMSB-b-PMMA) .

La polymérisation est conduite de façon anionique dans un mélange 50/50 (vol/vol) THF/heptane à -50°C par addition séquentielle des deux monomères avec l'amorceur butyl lithium secondaire (sec-BuLi).

Typiquement, dans un ballon de 250 ml sec flammé équipé d'un agitateur magnétique, on introduit du chlorure de lithium (85mg), 20 ml de THF et 20ml d'heptane. La solution est refroidie à -50°C. On introduit ensuite 0.00015 mole de sec-BuLi, suivi d'une addition de 0.01 mole de 1,1 diméthylsilacyclobutane. Le mélange réactionnel est agité 1 h puis on ajoute 0.2 ml de 1,1- diphényl éthylène. On rajoute 30 minutes après 0.01 mole de méthacrylate de méthyle et le mélange réactionnel est maintenu sous agitation durant 1h. On termine la réaction par un ajout de méthanol dégazé à - 50°C. Puis on concentre par évaporation le milieu réactionnel, suivi d'une précipitation au méthanol. Le produit est ensuite récupéré par filtration et séché à l'étuve à 35°C durant une nuit.

### Exemples 2-6.

Ces copolymères sont préparés selon le protocole de l'exemple 1 en faisant varier les quantités de réactifs. L'exemple 6 comparatif est préparé en utilisant le 1-butyl-1-methyl silacyclobutane (BMSB).

Les masses moléculaires et les dispersités correspondant au rapport entre masse moléculaire en poids (Mw) et masse moléculaire en nombre (Mn), sont obtenus par SEC (Size exclusion Chromatography), en utilisant 2 colonnes en série AGILENT 3µm ResiPore, en milieu THF stabilisé au BHT à un débit de 1mL/min à 40°C avec des échantillons concentrés à 1g/L, avec un étalonnage préalable avec des échantillons calibrés de polystyrène en utilisant un pack préparé Easical PS-2.

Les résultats sont donnés au tableau 1 :

**Tableau 1 :**

| Exemple | **Mn SEC (g/mol))** | **sec BuLi (mole)** | **mole DMSB ou BMSB** | **mole MMA** | **Composition polysiletane/PMMA (% massique)** | **Dispersité Mw/Mn** | **T°C d'autoassemblage (K)** |
|---|---|---|---|---|---|---|---|
| 1 (invention) | 10850 | 0,00015 | 0,01 | 0,01 | 43/57 | 1.15 | 453 |
| 2 (invention) | 16500 | 0,00001 | 0,01 | 0,0043 | 74/26 | 1.10 | 453 |
| 3 (invention) | 5100 | 0,00035 | 0,01 | 0,0043 | 77/23 | 1.05 | 373 |
| 4 (invention) | 5300 | 0,00035 | 0,01 | 0,0043 | 79/21 | 1.06 | 373 |
| 5 (invention) | 6600 | 0,00025 | 0,01 | 0,0043 | 74/26 | 1.08 | 453 |
| 6 (comparatif) | 7150 | 0,00025 | 0,0067 | 0,01 | 63/37 | 1.10 | 453 |

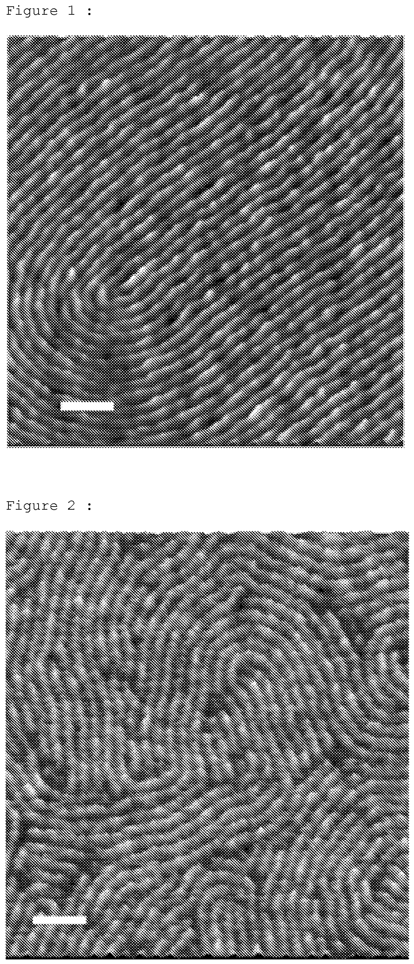

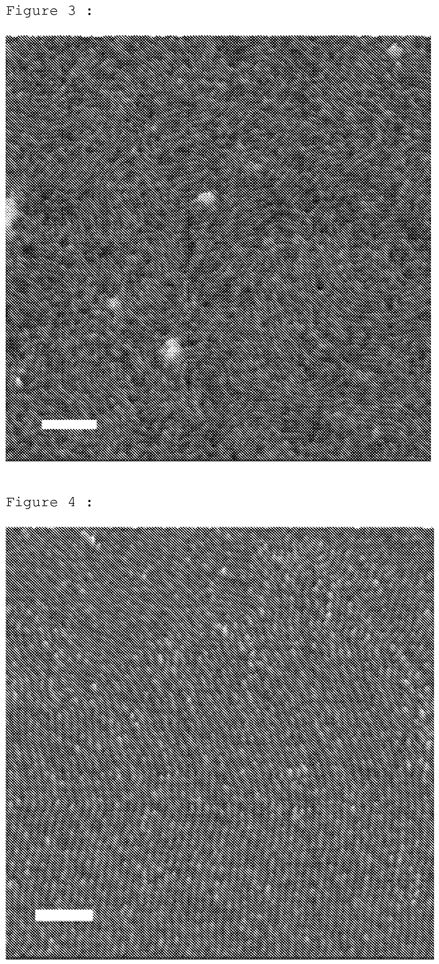

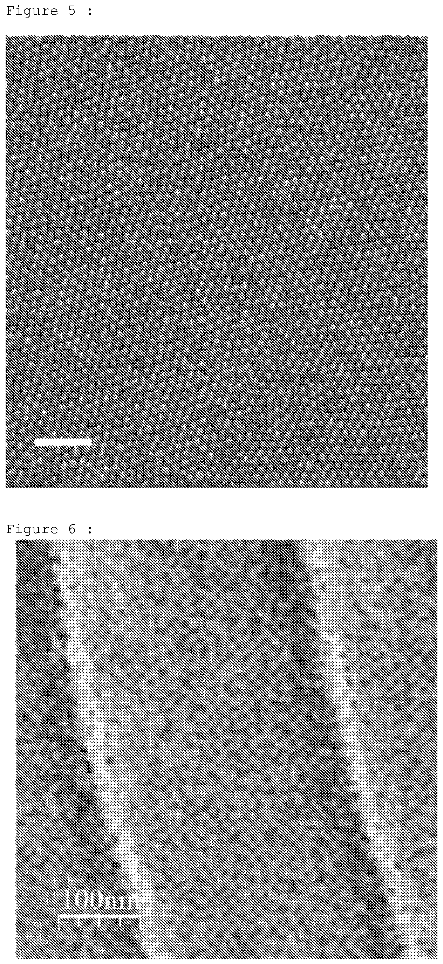

Les films des exemples 1 à 6 ont été préparés par spin coating à partir de solution à 1,5% en poids dans le toluène et l'épaisseur du film a été contrôlée en faisant varier la vitesse de spin-coating (de 1500 à 3000 rpm). Cette épaisseur est typiquement inférieure à 100 nm. La promotion de l'auto-assemblage inhérent à la ségrégation de phases entre les blocs du copolymère a été obtenue par des recuits courts (5 min) sur plaque chauffante à température modérée (entre 373 K et 453 K).
Les images AFM sont données dans les figures 1 à 6 et correspondent aux copolymères des exemples 1 à 6. On voit clairement que les copolymères à blocs objets de l'invention présentent un auto-assemblage, et ce même pour de faible masses moléculaires, alors que l'exemple 6 comparatif ne présente pas d'auto assemblage pour une faible masse moléculaire.
La figure 1 montre l'auto-assemblage en film mince du copolymère à blocs de l'exemple 1 présentant des lamelles orientés perpendiculairement au substrat. Échelle 100 nm.
La figure 2 montre l'auto-assemblage en film mince du copolymère à blocs de l'exemple 2 présentant des cylindres orientés parallèlement au substrat. Échelle 100 nm.
La figure 3 montre l'auto-assemblage en film mince du copolymère à blocs de l'exemple 3 présentant des cylindres orientés parallèlement au substrat. Échelle 100 nm.
La figure 4 montre l'auto-assemblage en film mince du copolymère à blocs de l'exemple 4 présentant des cylindres orientés parallèlement au substrat. Échelle 100 nm.
La figure 5 montre l'auto-assemblage en film mince du copolymère à blocs de l'exemple 5 présentant des cylindres orientés perpendiculairement au substrat. Échelle 100 nm.
La figure 6 montre l'absence d'auto assemblage du copolymère de l'exemple 6 en film mince, les lignes sont les guides servant à la promotion de l'autoassemblage en graphoépitaxie. Échelle 100 nm.

## Revendications

1. Procédé d'assemblage nano-structuré utilisant une composition comprenant un copolymère à blocs dont au moins un des blocs est constitué de 1,1-diméthyl-silacyclobutane et comprenant les étapes suivantes :
- Mise en solution du copolymère à blocs dans un solvant.
- Dépôt de cette solution sur une surface la dite surface étant choisie parmi le silicium, le silicium présentant une couche d'oxyde natif ou thermique, le silicium hydrogéné ou halogéné, le germanium, le germanium hydrogéné ou halogéné, le platine et oxyde de platine, le tungstène et oxydes, l'or, les nitrures de titane, les graphènes.
- Recuit.

2. Procédé selon la revendication 1 dans lequel le copolymère à blocs est un copolymère di-blocs.

3. Procédé selon la revendications 1 dans lequel le ou les blocs ne comprenant pas de 1,1-diméthyl-silacyclobutane comprennent du méthacrylate de méthyle dans des proportions massiques supérieures à 50%.

4. Procédé selon la revendication 1 dans lequel l'orientation du copolymère à bloc est effectuée durant un temps compris entre 1 et 20 minutes bornes comprises.

5. Procédé selon la revendication 1 dans lequel l'orientation du copolymère à bloc est effectuée à une température comprise entre 333 et 603 K.

6. Procédé selon la revendication 1 dans lequel le recuit est effectué sous atmosphère contrôlée comportant des vapeurs de solvant, ou une combinaison atmosphère de solvant/température.

7. Procédé selon la revendication 1 dans lequel l'assemblage nano-structuré a une épaisseur inférieure à 100 nm.

8. Utilisation du procédé selon une des revendications 1 à 7 dans le domaine de la lithographie, ou plus généralement dans le domaine de la nano-structuration de surfaces pour l'électronique.

9. Masque de copolymères à blocs obtenus selon le procédé d'une des revendications 1 à 7.

## Patentansprüche

1. Verfahren zur Nanostrukturierungsanordnung unter Verwendung einer Zusammensetzung, die ein BlockCopolymer umfasst, wobei mindestens einer der Blöcke aus 1,1-Dimethylsilacyclobutan besteht, und das folgende Schritte umfasst:
- Lösen des Block-Copolymers in einem Lösungsmittel,
- Aufbringen dieser Lösung auf einer Fläche, wobei die Fläche ausgewählt wird aus Silizium, wobei das Silizium eine natürliche oder thermisch erzeugte Oxidschicht aufweist, hydriertem oder halogeniertem Silizium, Germanium, hydriertem oder halogeniertem Germanium, Platin und Platinoxid, Wolfram und Oxiden, Gold, Titannitriden, Graphenen,
- Wärmebehandlung.

2. Verfahren nach Anspruch 1, wobei das BlockCopolymer ein Zweiblock-Copolymer ist.

3. Verfahren nach Anspruch 1, wobei der Block oder die Blöcke, der bzw. die kein 1,1-Dimethylsilacyclobutan umfasst bzw. umfassen, Methylmethacrylat in einem Massenanteil von über 50% umfasst bzw. umfassen.

4. Verfahren nach Anspruch 1, wobei die Ausrichtung des Block-Copolymers während eines Zeitraums zwischen einschließlich 1 und einschließlich 20 Minuten erfolgt.

5. Verfahren nach Anspruch 1, wobei die Ausrichtung des Block-Copolymers bei einer Temperatur zwischen 333 und 603 K erfolgt.

6. Verfahren nach Anspruch 1, wobei die Wärmebehandlung in kontrollierter Atmosphäre erfolgt, die Lösungsmitteldämpfe aufweist, oder eine Kombination Lösungsmittelatmosphäre/Temperatur ist.

7. Verfahren nach Anspruch 1, wobei die nanostrukturierte Anordnungseinheit eine Dicke unter 100 nm aufweist.

8. Verwendung des Verfahrens nach einem der Ansprüche 1 bis 7 im Bereich der Lithographie oder allgemeiner im Bereich der Nanostrukturierung von Oberflächen für die Elektronik.

9. Blockcopolymer-Maske, erhalten nach dem Verfahren nach einem der Ansprüche 1 bis 7.

## Claims

1. Nanostructured assembly process using a composition comprising a block copolymer, at least one of the blocks of which consists of 1,1-dimethylsilacyclobutane, and comprising the following steps:
- dissolving the block copolymer in a solvent,
- depositing this solution on a surface, said surface being chosen from silicon, silicon having a native or thermal oxide layer, hydrogenated or halogenated silicon, germanium, hydrogenated or halogenated germanium, platinum and platinum oxide, tungsten and oxides, gold, titanium nitrides and graphenes,
- annealing.

2. Process according to Claim 1, wherein the block copolymer is a diblock copolymer.

3. Process according to Claim 1, wherein the block or blocks not comprising 1,1-dimethylsilacyclobutane comprise methyl methacrylate in weight proportions of greater than 50%.

4. Process according to Claim 1, wherein the orientation of the block copolymer is carried out during a time of between 1 and 20 minutes, limits included.

5. Process according to Claim 1, wherein the orientation of the block copolymer is carried out at a temperature of between 333 K and 603 K.

6. Process according to Claim 1, wherein the annealing is carried out under a controlled atmosphere comprising solvent vapors, or a solvent atmosphere/temperature combination.

7. Process according to Claim 1, wherein the nanostructured assembly has a thickness of less than 100 nm.

8. Use of the process according to one of Claims 1 to 7, in the field of lithography, or more generally in the field of surface nanostructuring for electronics.

9. Block copolymer mask obtained according to the process of one of Claims 1 to 7.
